# EUROPEAN PATENT SPECIFICATION

(11) **EP 0 417 880 B1**
(45) Date of publication and mention of the grant of the patent: **15.01.1997**
(21) Application number: 90302176.4
(22) Date of filing: 01.03.1990
(51) Int. Cl.: C25D 5/18

(54) **Process for treating surface of copper foil**
Verfahren zur Behandlung einer Kupferfolienoberfläche
Procédé de traitement de la surface d'une feuille en cuivre

(30) Priority: 11.09.1989 JP 235166/89
(43) Date of publication of application: 20.03.1991
(73) Proprietor: MITSUI KINZOKU KOGYO KABUSHIKI KAISHA, Chuo-ku Tokyo-To (JP)
(72) Inventor: Kitamura, Nobuo, Ageo-Shi, Saitama-Ken (JP); Fujiki, Makoto, Kita-Adachi-Gun, Saitama-Ken (JP); Kodama, Yukio, Kashiwa-Shi, Chiba-Ken (JP); Yoshimura, Katsuhiro, Omiya-Shi, Saitama-Ken (JP)
(74) Representative: Higgins, Michael Roger

(56) References cited:
- EP-A- 0 112 635

## Description

The present invention relates to a process for treating a surface of a copper foil, for use in the production of a printed circuit board.

Generally, when a printed circuit board is manufactured, a copper-clad laminate is used in which a copper foil is bonded to a support substrate. In the manufacture of such a printed circuit board using a copper-clad laminate, the copper-clad laminate is first subjected to punching, and the insides of the punched holes are activated. Then copper is uniformly deposited by means of a non-electrolytic plating process, the copper also being electroplated to augment its thickness. After application of photoresist to the surface of the copper foil, pattern etching is conducted to produce the configured circuit board. During the activating treatment of the inside of the punched holes and the pattern etching treatment, a bonding boundary layer between the copper foil and the substrate is exposed to a solution containing hydrochloric acid, and, after pattern etching has been completed, the copper foil is immersed several times in various plating solutions and acid cleaning solutions as a pretreatment to the conducting of various plating steps.

Thus the bonding boundary layer between the copper foil and the substrate may sometimes be corroded by acid so as to cause the bond strength to deteriorate. Also, for bonding of the copper foil to the substrate, it may be heated to permit bonding under pressure. Therefore, the stability of the bond between the copper foil and the substrate becomes important in the preparation of the printed circuit board.

For this reason, a surface treatment may be applied to the surface by which the copper foil is bonded to the substrate, by means of electrodeposition which is carried out using the copper foil as a cathode. For example in order to enhance the bond strength between the copper foil and the substrate, a granular copper layer may be electrically deposited on the surface of the copper foil by burned plating, to thereby form a roughened surface. To prevent falling off of the granular copper layer, smooth copper plating may be applied at a limiting current density or less, and the electroplated surface may be coated with a metal, such as zinc, zinc alloy or the like for the purpose of providing rust resistance and heat resistance.

One such treatment process is disclosed in EP-A-0112635.

However, such a combination of copper foil covered with zinc or zinc alloy has not provided satisfactory resistance to hydrochloric acid. For example, when the section of the copper foil produced by punching or pattern etching of the copper-clad laminate is exposed to a solution containing hydrochloric acid during production of the printed circuit board, acid corrosion is caused at the boundary between the zinc/zinc alloy corrosion resistant layer and the substrate, resulting in bond strength stability problems.

It is an object of the present invention to provide a process for treating a surface of a copper foil for use in the production of a printed circuit board without creating safety problems, so as to provide good heat resistance and so as to provide significantly improved resistance to hydrochloric acid.

According to the present invention there is provided a process for treating a surface of a copper foil comprising the steps of roughening the surface of the copper foil by electrically depositing on the surface a granular copper layer by burned plating, and by then applying smooth copper plating to said granular copper layer, and forming in turn on the roughened surface of the copper foil a zinc barrier layer and a chromate rust-resistant layer, characterised in that a further copper layer is applied between the zinc barrier layer and the chromate rust-resistant layer.

The copper foil which is the subject of the present invention may be electro-deposited copper foil or wrought copper foil treated to render the surface rough.

If necessary an additional zinc layer may be formed between the further copper layer and the chromate rust-resistant layer.

In order that the invention may be more fully understood, a preferred embodiment of the invention will now be described by way of example.

Zinc is first electroplated onto the roughened surface of the copper foil which has been produced by electrically depositing a granular copper layer by burned plating and by then applying smooth copper plating to the granular copper layer. An electrolyte bath used for the electroplating of this zinc makes use of various well known techniques, and it is not necessary to describe this in detail. However, as one example, the following bath composition and electroplating conditions may be used in a potassium pyrophosphate bath:

| | |
|---|---|
| Potassium pyrophosphate | 50 to 150 g/ℓ |
| Zinc pyrophosphate (tetrahydrate) | 8 to 30 g/ℓ |
| pH | 10.5 to 11.5 |
| Temperature of bath | 35 to 50°C |
| Cathode | copper foil |
| Anode | zinc plate |
| Cathode current density | 1 to 5 A/dm² |
| Electroplating time | 5 to 15 sec. |

In the range of the above-stated electroplating conditions, conditions are selected so that a desired amount of electrodeposition is obtained. As the amount of electrodeposition of zinc increases, so heat resistance is more improved; however, preferable amount is 100 to 1000 mg/m².

To the copper foil onto which zinc is electroplated by the above-stated step, is then applied copper electroplating. This electroplating is preferably performed in an alkali bath. Although a potassium pyrophosphate bath, a cyanide bath and the like are exemplified as a well known bath, one example of using a potassium pyrophosphate bath which is preferable from the respect of safety is shown in the followings with its electroplating condition:

| | |
|---|---|
| Potassium pyrophosphate | 150 to 400 g/ℓ |
| Copper pyrophosphate (trihydrate) | 4 to 100 g/ℓ |
| pH | 7.5 to 8.5 |
| Temperature of bath | 45 to 55°C |
| Cathode | copper foil |
| Anode | copper plate |
| Cathode current density | 3 to 9 A/dm² |
| Electroplating time | 5 to 20 sec. |

In the above-stated range electroplating conditions are selected so that a desired amount of electrodeposition is obtained. This electroplating is preferably performed in a small amount enough to make the color tone of the surface covered with copper uniform, and if it becomes excessive, heat resistance decreases. The amount of copper electroplated is preferably 1000 to 5000 mg/m².

To the surface of copper foil electroplated with copper on the zinc layer by the above-stated step, is applied zinc electroplating, again, according to necessity; however, its amount is significantly small. An alkali bath is preferable for the method. One example of the electroplating condition using a potassium pyrophosphate bath is shown in the following.

| | |
|---|---|
| Potassium pyrophosphate | 20 to 50 g/ℓ |
| Zinc pyrophosphate (tetrahydrate) | 3 to 6 g/ℓ |
| pH | 10.5 to 11.5 |
| Temperature of bath | 35 to 45°C |
| Cathode | copper foil |
| Anode | zinc plate |
| Cathode current density | 0.1 to 0.3 A/dm² |
| Electroplating time | 2 to 6 sec. |

The amount of zinc electrodeposited is decided as the upper limit in the range where the color of zinc is not noticed on the color tone of electroplating surface and is finely controlled in accordance with visual observation.

Then, chromate treatment is applied to the surface to be treated. This method includes various well known techniques and is not necessary to be specified; however, as one example, there are shown, in the following, the bath composition and electroplating conditions in the case of performing electrolytic chromate treatment for rust resistance by a chromic acid bath.

| | |
|---|---|
| Anhydrous chromic acid | 0.7 g/ℓ |
| Temperature of bath | 25 to 30°C |
| Cathode | copper foil |
| Anode | insoluble anode |
| Cathode current density | 0.5 A/dm² |
| Treating time | 5 sec. |

The above-stated treating process is applied by passing through respective steps of zinc plating, water rinsing, copper plating, water rinsing, if necessary zinc plating and water rinsing, chromate treatment for rust resistance, water rinsing, and drying in turn.

The copper foil thus treated is heated to fix it under pressure to a glass epoxy FR-4 substrate or the like to prepare a copper-clad laminate.

### Comparative Examples

Onto the surface of the copper foil which has been roughened by a conventionally known roughening method, such as the two-stage plating process already described, there were formed the zinc layer, the copper layer, and the chromate rust resistant layer, as shown in Table 1, in the range of electroplating baths and electroplating conditions already described. The product thus obtained was heated to fix it under pressure to a glass epoxy FR-4 substrate to prepare a copper-clad laminate.

The heat deterioration of the bond strength and hydrochloric acid resistance in these copper-clad laminates were tested. Heat resistance is expressed by copper foil peeling strength at 177°C after 10 days of heating, and a value of 0.36 kg/cm or more is demanded. Hydrochloric acid resistance is expressed by a degradation ratio of copper foil peeling strength obtained after immersing for 30 minutes a patterned piece of 0.8mm wide in hydrochloric acid diluted in the ratio of 1 to 2, and a value of 10% or less is demanded.

Test pieces of conventional samples in which only a chromate rust resistant layer was formed and in which a zinc layer and a chromate rust resistant layer were formed were similarly tested.

It will be appreciated from Table 1 that, whilst it is difficult for the conventional samples to satisfy simultaneously both the heat resistance performance and the hydrochloric acid resistance performance, copper foil treated by a method in accordance with the features of claim 1 of the present invention can fully satisfy both performances.

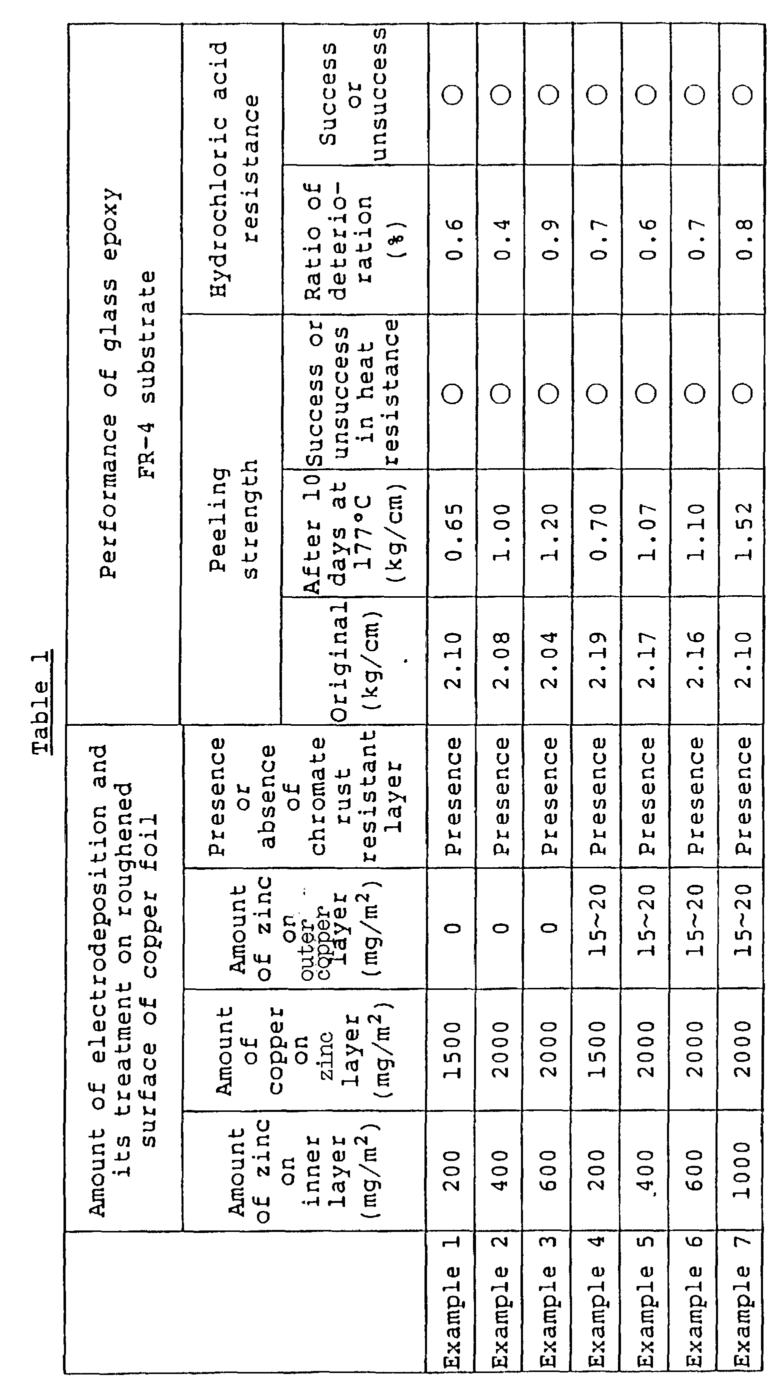

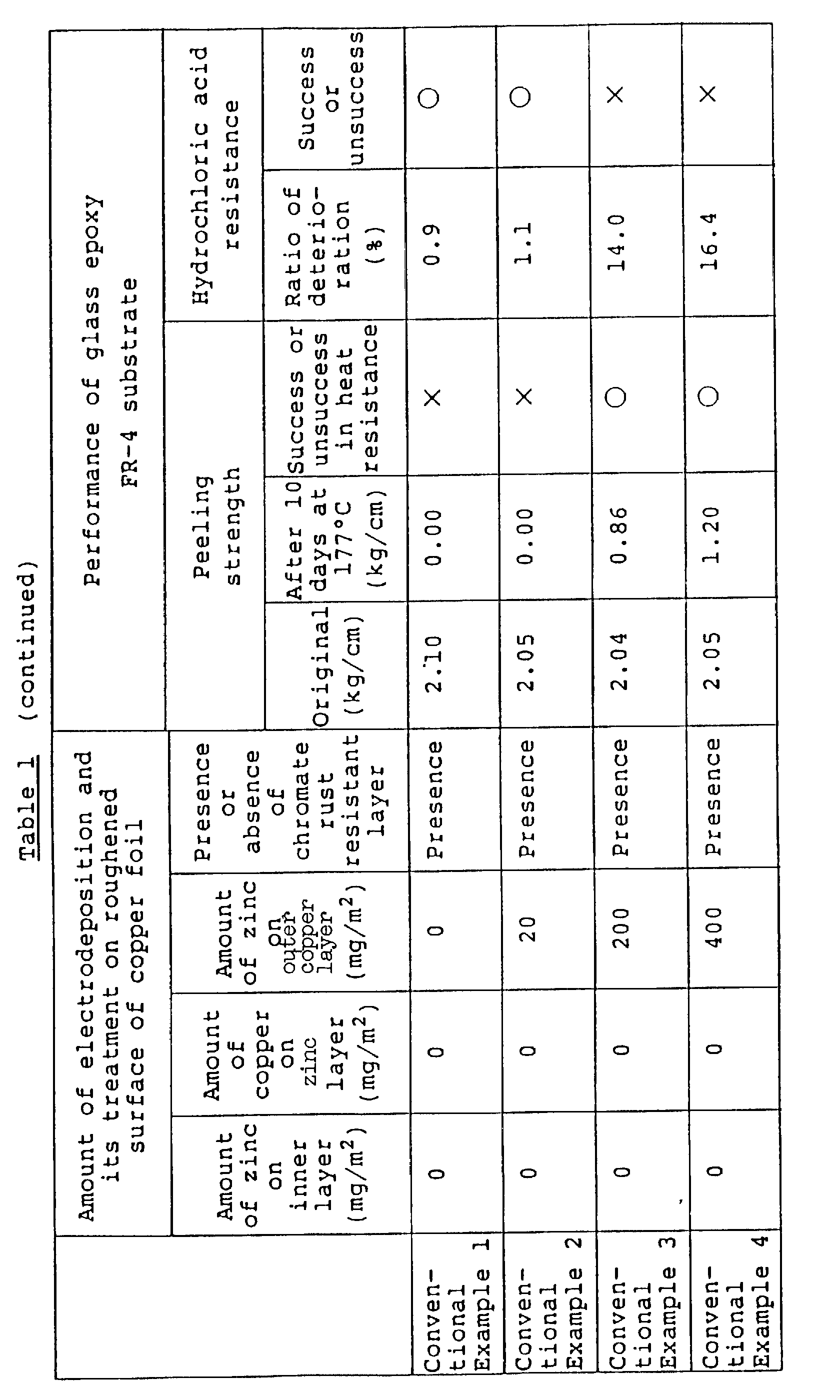

The copper foil surface-treated in accordance with the process of the present invention is excellent in heat resistance and hydrochloric acid-resistance on preparing a printed circuit board and the process does not require the use of dangerous chemicals such as cyanide and the like and is free from any problems regarding safety, leading to a significantly useful invention.

## Claims

1. A process for treating a surface of a copper foil comprising the steps of roughening the surface of the copper foil by electrically depositing on the surface a granular copper layer by burned plating, and by then applying smooth copper plating to said granular copper layer, and forming in turn on the roughened surface of the copper foil a zinc barrier layer and a chromate rust-resistant layer, characterised in that a further copper layer is applied between the zinc barrier layer and the chromate rust-resistant layer.

2. A process according to claim 1, wherein a further zinc layer is additionally formed between the further copper layer and the chromate rust-resistant layer.

3. A process according to claim 1 or 2, wherein the zinc barrier layer is formed by electroplating.

4. A process according to claim 3, wherein the amount of zinc deposited in the zinc barrier layer is in the range of 100 to 1000 mg/m².

5. A process according to any preceding claim, wherein the further copper layer is applied between the zinc barrier layer and the chromate rust-resistant layer by electroplating in an alkali bath.

6. A process according to claim 5, wherein the amount of copper deposited in the further copper layer is in the range of 1000 to 5000 mg/m².

7. A process according to claim 2 or any one of claims 3 to 6 when appended directly or indirectly to claim 2, wherein the further zinc layer is formed by electroplating in an alkali bath.

8. A process according to claim 7, wherein the amount of zinc deposited in the further zinc layer is in the range of 0 to 20 mg/m².

9. A copper foil treated by a process according to any preceding claim.

10. A printed circuit board incorporating a copper foil according to claim 9.

## Patentansprüche

1. Verfahren zur Oberflächenbehandlung einer Kupferfolie umfassend die Behandlungsstufen: Aufrauhen der Oberfläche der Kupferfolie durch elektrolytische Abscheidung einer granularen Kupferschicht auf der Oberfläche durch Brennplattierung und danach durch Aufbringen einer glatten Kupferplattierung auf die granulare Kupferschicht und ferner durch Aufbringen einer Zinksperrschicht und einer rostbeständigen Chromatschicht auf die gerauhte Oberfläche der Kupferfolie, dadurch gekennzeichnet, daß zwischen der Zinksperrschicht und der rostbeständigen Chromatschicht eine weitere Kupferschicht aufgebracht wird.

2. Verfahren nach Anspruch 1, wonach zusätzlich eine weitere Zinkschicht zwischen der weiteren Kupferschicht und der rostbeständigen Chromatschicht geformt wird.

3. Verfahren nach Anspruch 1 oder 2, wonach die Zinksperrschicht durch Elektroplattieren geformt wird.

4. Verfahren nach Anspruch 3, wonach die in der Zinksperrschicht abgeschiedene Zinkmenge zwischen 100 und 1000 mg/m² liegt.

5. Verfahren nach einem der vorstehenden Ansprüche, wonach die weitere Kupferschicht zwischen der Zinksperrschicht und der rostbeständigen Chromatschicht durch Elektroplattierung in einem Alkalibad aufgebracht wird.

6. Verfahren nach Anspruch 5, wonach die in der weiteren Kupferschicht abgeschiedene Kupfermenge zwischen 1000 und 5000 mg/m² liegt.

7. Verfahren nach Anspruch 2 oder einem der unmittelbar oder mittelbar von Anspruch 2 abhängigen Ansprüche 3 bis 6, wonach die weitere Zinkschicht durch Elektroplattieren in einem Alkalibad aufgebracht wird.

8. Verfahren nach Anspruch 7, wonach die in der weiteren Zinkschicht abgeschiedene Zinkmenge zwischen 0 und 20 mg/m² liegt.

9. Kupferfolie behandelt nach einem Verfahren entsprechend einem der vorstehenden Ansprüche.

10. Gedruckte Leiterkarte umfassend eine Kupferfolie nach Anspruch 9.

## Revendications

1. Procédé de traitement d'une surface d'une feuille de cuivre comprenant les étapes consistant à rendre rugueuse la surface de la feuille de cuivre en déposant électriquement sur la surface une couche de cuivre granulaire par placage au four, puis en appliquant un placage de cuivre lisse sur ladite couche de cuivre granulaire, et à former tour à tour sur la surface rendue rugueuse de la feuille de cuivre une couche barrière de zinc et une couche de chromate résistante à la rouille, caractérisé en ce qu'une couche de cuivre supplémentaire est appliquée entre la couche barrière de zinc et la couche de chromate résistante à la rouille.

2. Procédé selon la revendication 1, dans lequel une couche de zinc supplémentaire est en outre formée entre la couche de cuivre supplémentaire et la couche de chromate résistante à la rouille.

3. Procédé selon la revendication 1 ou 2, dans lequel la couche barrière de zinc est formée par placage électrolytique.

4. Procédé selon la revendication 3, dans lequel la quantité de zinc déposée dans la couche barrière de zinc est dans la plage allant de 100 à 1000 mg/m².

5. Procédé selon l'une quelconque des revendications précédentes, dans lequel la couche de cuivre supplémentaire est appliquée entre la couche barrière de zinc et la couche de chromate résistante à la rouille par placage électrolytique dans un bain alcalin.

6. Procédé selon la revendication 5, dans lequel la quantité de cuivre déposée dans la couche de cuivre supplémentaire est dans la plage allant de 1000 à 5000 mg/m².

7. Procédé selon la revendication 2 ou l'une quelconque des revendications 3 à 6 lorsqu'elles dépendent directement ou indirectement de la revendication 2, dans lequel la couche de zinc supplémentaire est formée par placage électrolytique dans un bain alcalin.

8. Procédé selon la revendication 7, dans lequel la quantité de zinc déposée dans la couche de zinc supplémentaire est dans la plage allant de 0 à 20 mg/m².

9. Feuille de cuivre traitée par un procédé selon l'une quelconque des revendications précédentes.

10. Carte de circuit imprimé incorporant une feuille de cuivre selon la revendication 9.
